(19) Europäisches Patentamt
European Patent Office
Office européen des brevets

(11) **EP 2 006 694 B1**

(12) **FASCICULE DE BREVET EUROPEEN**

(45) Date de publication et mention
de la délivrance du brevet:
**21.03.2018 Bulletin 2018/12**

(51) Int Cl.:
***G01R 31/02*** *(2006.01)*   ***G01R 31/08*** *(2006.01)*
*G01R 27/18* *(2006.01)*   *H02H 3/17* *(2006.01)*

(21) Numéro de dépôt: **08354033.6**

(22) Date de dépôt: **03.06.2008**

(54) **Dispositif de contrôle et de mesure localisés d'isolement pour réseau électrique à neutre isolé**

Vorrichtung zur lokalisierten Kontrolle und Messung der Isolierung von Stromnetzen mit isoliertem Nullleiter

Localised insulation control and measurement device for a power grid with insulated neutral

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **21.06.2007 FR 0704426**

(43) Date de publication de la demande:
**24.12.2008 Bulletin 2008/52**

(73) Titulaire: **Schneider Electric Industries SAS**
**92500 Rueil-Malmaison (FR)**

(72) Inventeur: **Vincent, François**
**38050 Grenoble Cedex 09 (FR)**

(74) Mandataire: **Colette, Marie-Françoise et al**
**Schneider Electric Industries SAS**
**Service Propriété Industrielle**
**WTC - E1**
**5, place Robert Schuman**
**38050 Grenoble Cedex 09 (FR)**

(56) Documents cités:
**EP-A- 1 304 580      EP-A2- 0 593 007**
**DE-A1- 10 151 160    DE-A1- 10 307 972**
**DE-C1- 10 143 595    FR-A- 2 647 220**
**FR-A- 2 676 821      FR-A- 2 679 039**
**JP-A- 2007 071 774   US-A- 5 495 384**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE**

L'invention concerne un dispositif de contrôle et de mesure d'isolement, plus couramment dénommé « contrôleur permanent d'isolement » et connu sous l'acronyme CPI, pour un réseau de distribution électrique à neutre isolé comprenant des dérivations. L'invention se rapporte plus particulièrement à la localisation des défauts de fuite et à la détermination de leur impédance.

**ETAT DE LA TECHNIQUE**

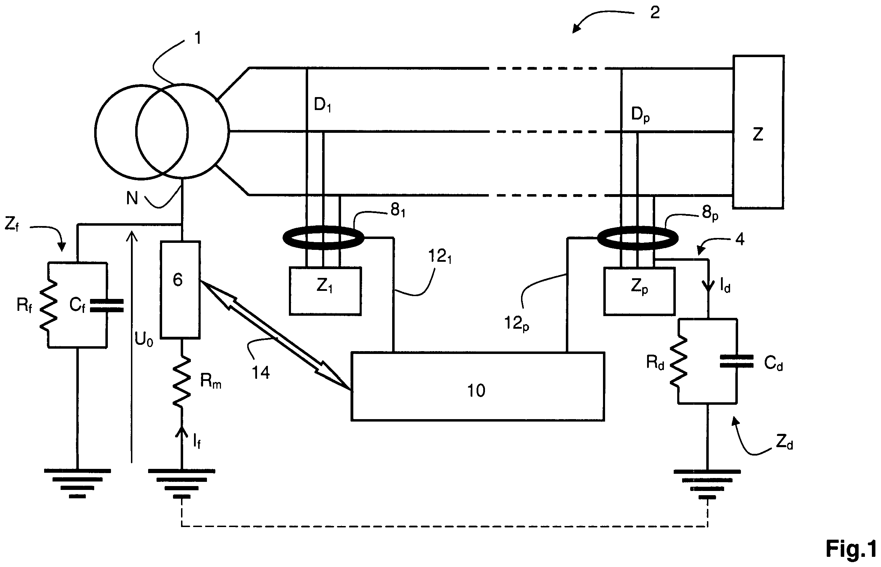

En se référant à la figure 1, un transformateur triphasé 1 alimente en énergie électrique alternative les trois barres de distribution d'un réseau 2 ; le réseau principal 2 fournit de l'énergie électrique à une impédance de charge Z, ainsi qu'à plusieurs impédances d'utilisation $Z_j$ branchées chacune sur une dérivation triphasée $D_j$ (j = 1→p) du réseau principal 2. Le réseau 2 est dit « à neutre isolé », c'est-à-dire que les impédances de charge Z et d'utilisation $Z_j$ sont connectées entre une phase et le neutre N ou entres phases, et non par rapport à la terre.

Il peut survenir qu'une des impédances de charge ou d'utilisation, ici au niveau d'une dérivation $D_p$, présente un défaut d'isolement 4 par rapport à la terre, qui se traduit par la présence dommageable d'une impédance de défaut $Z_d$ entre au moins un des trois fils de phase et la terre ; une impédance de défaut $Z_d$ est usuellement schématisée par un circuit additionnel comprenant une résistance $R_d$ en parallèle avec une capacité $C_d$.

Pour détecter et mesurer la présence de ce type de fuite, un contrôleur permanent d'isolement, ou CPI, 6 est branché en série avec une résistance de mesure $R_m$, par exemple entre le neutre isolé N et la terre ; il injecte sur le réseau d'alimentation 2 une tension alternative $U_0$ de fréquence différente et usuellement inférieure à la fréquence propre $F_0$ du courant d'alimentation. En présence du défaut d'isolement 4, l'injection sur le réseau 2 de la tension $U_0$ entraîne la circulation d'un courant de fuite $I_f$, à la fréquence de la tension injectée $U_0$, dans l'impédance de défaut $Z_d$ qui se boucle vers le CPI 6 à travers la terre et la résistance de mesure $R_m$. De fait, le(s) défaut(s) peu(ven)t être schématisé(s) par la présence d'une impédance de fuite $Z_f$ au niveau du CPI 6 sur le neutre N.

Le CPI 6 comprend classiquement des moyens adaptés, par exemple par démodulation synchrone et par détermination des parties réelle et imaginaire des vecteurs représentatifs de la tension injectée $U_0$ et du courant de fuite $I_f$, pour déterminer les valeurs de la résistance $R_f$ et de la capacité $C_f$ de fuite. Un exemple est donné dans le document FR 2 647 220.

Il peut en outre être important de localiser et déterminer le défaut 4 détecté au niveau central par le CPI 6 : la parfaite connaissance du défaut 4 et de ses caractéristiques $R_d$, $C_d$ permet d'adapter sa correction, sans présumer que le défaut 4 est résistif par nature (tel que présenté dans DE 101 435 95). Il a ainsi été proposé dans le document FR 2 676 821, de mettre en place sur chacune des dérivations $D_j$ des moyens de mesure $8_j$ du courant de défaut local $I_d$, c'est-à-dire du courant résultant de la somme des courants de phase, parcourant la dérivation $D_j$ et causé par le signal alternatif injecté dans le réseau 2 par le CPI 6 ; par exemple, un transformateur de mesure d'intensité à tore $8_j$ est placé autour de tous les conducteurs de chacune des dérivations $D_j$ et son signal de mesure est communiqué à des moyens de traitement et calcul 10, aussi appelés localisateur, via une ligne $12_j$. Un traitement par démodulation ou détection synchrone de l'intensité mesurée $I_d$ en fonction du signal injecté $U_0$ permet de déterminer la valeur $Z_d$ de l'impédance locale de fuite ; à cette fin, un signal de synchronisation est envoyé par le CPI 6 au localisateur 10, par l'intermédiaire d'une liaison synchrone adaptée, généralement un bus de communication 14.

Ce système donne de bons résultats. Cependant, sa mise en oeuvre est lourde, en particulier du fait de l'indispensable synchronisation entre la mesure locale du courant de fuite $I_d$ et l'injection centrale de la tension $U_0$ : les liaisons 14, obligatoirement synchrones, permettant la communication au localisateur 10 des données démodulées de la tension d'injection $U_0$ compliquent la mise en place des CPI 6 et localisateur 10, en particulier lors de la multiplication des dérivations $D_j$ et de leur éloignement relatif.

Les documents DE 103 07 972 A1 ou JP 2007 071774 A ou EP 0 593 007 A2 divulguent un dispositif de mesure selon le préambule de la revendication 1.

**EXPOSE DE L'INVENTION**

Parmi autres avantages, l'invention vise à pallier des inconvénients des systèmes de localisation de défauts de fuite existants, et en particulier à alléger la mise en oeuvre d'un dispositif de mesure locale d'une impédance de fuite par suppression des bus de communication.

Sous un aspect, l'invention concerne un dispositif de contrôle et de mesure de l'isolement d'une dérivation d'un réseau électrique à neutre isolé comprenant des moyens pour injecter un signal de courant alterné d'une première fréquence dans le réseau. Avantageusement, les moyens d'injection font partie d'un contrôleur permanent d'isolement qui comprend également des moyens pour mesurer l'intensité de fuite y circulant et déterminer l'impédance de fuite au niveau du contrôleur. Les moyens d'injection sont aptes à également injecter, notamment simultanément, au moins un signal de courant alterné d'une deuxième fréquence dans le réseau ; avantageusement, les différentes fréquences d'injection sont des multiples l'une de l'autre ; de préférence, il s'agit de sous-multiples de la fréquence propre du réseau lorsque celui-ci est alimenté par un courant alternatif, monophasé ou triphasé.

Le dispositif de contrôle et mesure selon l'invention comprend en outre, placés sur la dérivation à contrôler, des moyens de mesure du courant de défaut et des moyens de mesure de la tension de défaut ; les moyens de mesure du courant de défaut comprennent notamment un tore de détection entourant la ligne d'alimentation de la dérivation (par exemple phases et/ou neutre). Avantageusement, les mesures sont simultanées et les moyens de mesure sont étalonnés par détermination de leur gain et leur phase, par exemple régulièrement, afin de s'affranchir de leurs paramètres. De préférence, les moyens de mesure du courant et de la tension de défaut sont adaptés pour mesurer simultanément le courant et la tension à plusieurs fréquences, correspondant aux différentes fréquences de courant injecté.

Les mesures du courant et de la tension réalisées sur l'ensemble de la dérivation sont transmises à un système de traitement du dispositif selon l'invention. Le système de traitement permet la détermination de l'impédance de défaut en fonction de la tension et du courant de première fréquence, et éventuellement des autres fréquences injectées. Les moyens de détermination dépendent de l'information souhaitée : selon un premier mode de réalisation préféré, le système de détermination comprend des moyens d'évaluation de la nature de l'impédance de défaut en fonction du rapport entre les amplitudes de la tension et du courant de défaut à la première fréquence et à une deuxième fréquence. Le dispositif selon l'invention comprenne en outre des moyens d'asservissement de la tension injectée de façon à avoir une amplitude de la tension de défaut sur la dérivation constante quelle que soit la fréquence d'injection ; il n'est alors plus nécessaire de la mesurer.

Lorsque le réseau comprend plusieurs dérivations, le dispositif selon l'invention peut comprendre, sur chaque dérivation à contrôler, des moyens de mesure du courant et de la tension de la dérivation, avantageusement identiques mais qui peuvent également consister en différentes alternatives. Le système de traitement peut alors être démultiplié et comprendre des moyens de détermination d'une impédance locale pour chaque dérivation, ou centralisé et comprendre des moyens de détermination de chaque impédance.

Selon un mode de réalisation, des moyens de liaison entre le contrôleur permanent d'isolement et le(s) système(s) de détermination de l'impédance de défaut locale permettent un transfert des informations et/ou résultats.

Selon un autre aspect, l'invention concerne un réseau électrique muni de dérivations comprenant un dispositif pour contrôler et mesurer l'isolement local des dérivations tel que présenté plus haut. L'invention est également relative à une installation comprenant une pluralité de réseaux couplés par des dispositifs de coupure, plusieurs des sous-réseaux comprenant des contrôleurs permanents d'isolement et un d'entre eux au moins étant muni d'un dispositif de mesure et contrôle tel que défini plus haut.

## BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.

La figure 1, déjà décrite, illustre le fonctionnement d'un contrôleur d'isolement dans un réseau existant.

La figure 2 montre un dispositif de contrôle et mesure selon un mode de réalisation préféré de l'invention.

La figure 3 représente schématiquement un étalonnage préconisé dans un mode de réalisation préféré de l'invention.

Les figures 4A et 4B montrent des modèles pour les impédances de fuite.

La figure 5 illustre un réseau selon un autre mode de réalisation préféré de l'invention.

## DESCRIPTION DETAILLEE D'UN MODE DE REALISATION PREFERE

Le dispositif selon l'invention peut reprendre les mêmes éléments quant au CPI 6 que le dispositif présenté précédemment en relation avec la figure 1 ; l'homme du métier peut également remplacer ce CPI par d'autres équivalents connus et commercialisés.

Dans un mode de réalisation préféré de l'invention, un réseau 20 est associé à un CPI 22 qui comprend des moyens 24 pour générer et injecter un signal de courant alternatif d'une première fréquence $f_1$ dans le réseau 20, de préférence au niveau du neutre. Usuellement, et bien que ces éléments ne soient pas indispensables à l'invention, le CPI 22 comprend des moyens connus 26 pour détecter et/ou mesurer l'intensité $I_f$ du courant généré à la première

fréquence $f_1$ à son niveau ; le CPI 22 comprend également des moyens de détermination, voire de visualisation, 28 de l'impédance de fuite générale $Z_f$ du réseau 20 grâce à la connaissance de la tension injectée $U_0$.

Pour un réseau d'alimentation triphasée de fréquence propre $F_0$, avantageusement, la première fréquence $f_1$ est un sous-multiple de la fréquence propre $F_0$ afin de simplifier la détection de la réponse et la démodulation synchrone ; notamment, pour un réseau fonctionnant à $F_0$ = 50 Hz, la première fréquence $f_1$ peut être de 1,25 Hz, 2,5 Hz, 5 Hz ou 10 Hz. Le choix dépend de compromis entre puissance et détection connus de l'homme du métier. En particulier, certains réseaux 20 comportent des perturbations importantes de très basse fréquence avec un spectre très large, dont il est préférable de s'écarter pour $f_1$ afin d'obtenir des mesures fiables : par exemple, un four commandé par un train d'impulsions de 100 ms toutes les secondes génère des raies tous les Hertz.

Selon une option, une analyse spectrale réalisée par l'intermédiaire d'une transformée de Fourier rapide (FFT) discrète sans signal d'injection permet de déterminer les perturbations présentes sur le réseau 20 et ainsi d'éviter de choisir une fréquence d'injection $f_1$ qui en serait proche ; avantageusement, pour garantir un bon fonctionnement, la FFT est reconduite périodiquement. Par ailleurs, les moyens de détermination et/ou mesure 26, 28 implémentent, sur l'acquisition de chaque échantillon, de préférence un filtrage numérique passe bande centré sur la fréquence d'injection $f_1$ afin de ne pas être sensibles à un spectre de plusieurs raies proches les unes des autres.

Le réseau 20 auquel s'applique le dispositif de contrôle et de mesure 30 selon l'invention comprend au moins une dérivation D. Afin de localiser une impédance de défaut $Z_d$ éventuelle de cette dérivation D, selon l'invention, l'intensité $I_d$ et la tension $U_d$ du courant y circulant, et résultant de l'injection par les moyens 24 du CPI 22, sont mesurées localement. Contrairement à ce qui est par exemple décrit dans le document US 5 495 384, l'intensité $I_d$ mesurée concerne le courant de défaut, c'est-à-dire la résultante sur l'ensemble des conducteurs de la dérivation D : il ne s'agit pas de mesurer l'intensité circulant dans chaque phase, mais l'intensité de la ligne, infiniment plus faible ; en particulier, la mesure des courants dans trois conducteurs d'une ligne triphasée n'est pas adaptée à la mesure d'un courant de défaut.

A cette fin, sur la dérivation D se trouvent des moyens 32 pour mesurer le courant de défaut $I_d$ à la première fréquence $f_1$, notamment un tore de détection 34, entourant l'ensemble des conducteurs d'alimentation de la dérivation D, qui est associé à un circuit de mesure 36 de type classique ; de plus, des moyens 38 pour mesurer la tension à la première fréquence $f_1$ sont placés sur la dérivation D, ici encore pour l'ensemble de la ligne. Les résultats $I_d$, $U_d$ sont envoyés à un système de traitement 40.

Certes, une mesure au même endroit de la tension et du courant, telle que choisie dans la solution selon l'invention, semble une démarche évidente. Cependant, ce type de détermination n'a pas été appliqué pour des dispositifs 30 permettant la localisation des impédances de fuite, ni sur des dérivations. De fait, la double mesure et ses inconvénients inhérents, en particulier le déphasage introduit par le tore de détection du courant qui affecte la détermination de la tension, étaient évités et l'homme du métier utilisait, pour le transfert des paramètres de synchronisation, le câblage implicite de la localisation, qui entraîne usuellement le transfert des résultats vers une unité centrale.

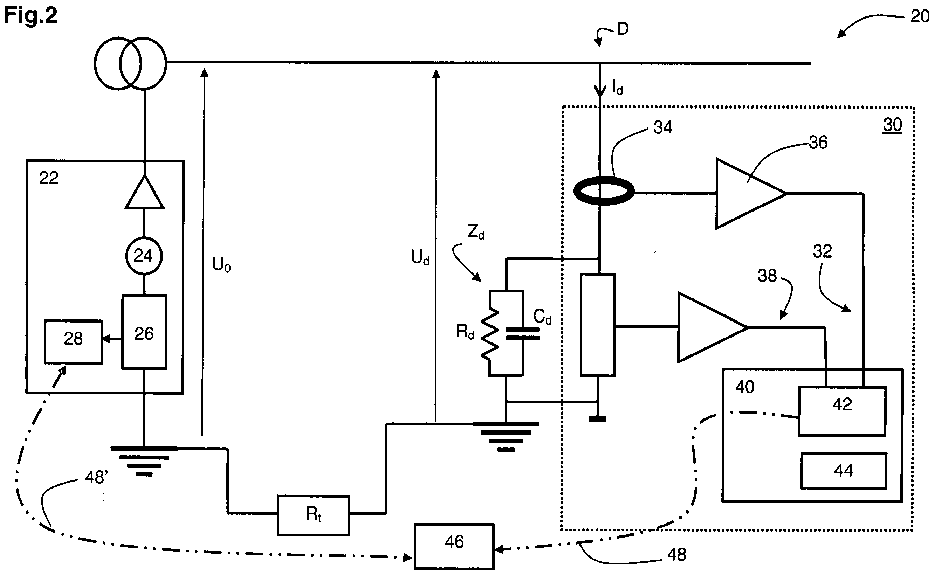

Dans un mode de réalisation particulièrement préféré permettant en outre d'accélérer la mesure, illustré en figure 2, les mesures du courant et de la tension sont simultanées et réalisées en parallèle par deux chaînes distinctes, comprenant usuellement un filtrage et une amplification ; de préférence, cette solution est également choisie au niveau des moyens de mesure 26 du CPI 22 injecteur.

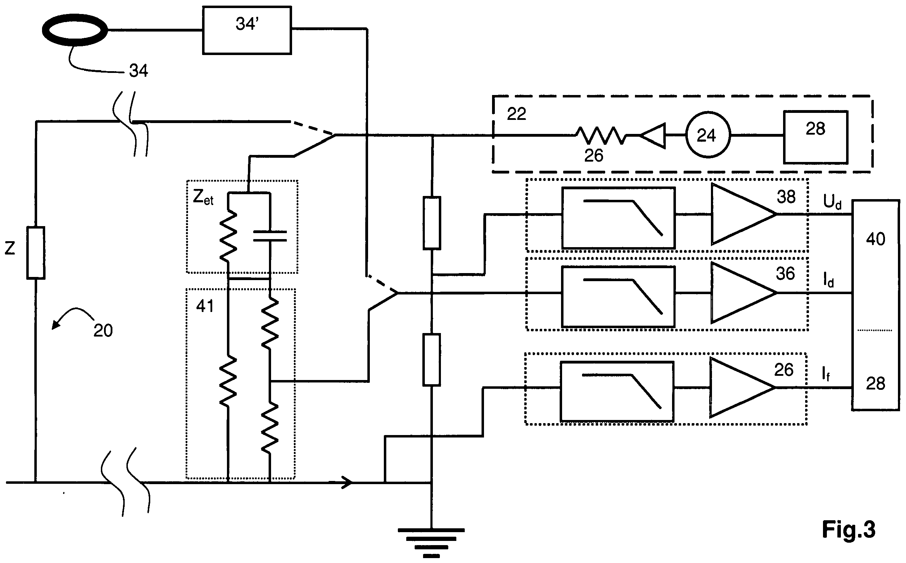

Ce choix préconisé par l'invention implique des modifications, *a priori* rédhibitoires pour l'homme du métier, dans les protocoles de calcul afin de compenser le fait que deux chaînes de mesure sont utilisées, en particulier pour s'affranchir des paramètres de leurs composants et du déphasage inhérent entre les valeurs de $I_d$ et $U_d$. A cette fin, un étalonnage est préalablement réalisé : une impédance d'étalonnage $Z_{et}$, résistance pure $R_{et}$ ou en parallèle avec une capacité $C_{et}$, dont les caractéristiques sont déterminées précisément et stables dans le temps, est mise en place sur le circuit concerné tel qu'illustré en figure 3.

Dans un premier temps d'étalonnage, le CPI 22 injecte la tension $U_0$ dans l'impédance d'étalonnage $Z_{et}$ et non dans le réseau 20 (respectivement la dérivation D), par exemple par l'intermédiaire d'un interrupteur ou d'un relai ; de préférence, si un tore 34 de mesure est utilisé, ses caractéristiques sont également prises en compte lors de l'étalonnage grâce à un dispositif 41 de simulation des capteurs de courant (tore 34 et interface associée 34') ; le dispositif de simulation 41 peut naturellement prendre d'autres formes que l'association de résistances illustrée, notamment un tore de caractéristiques identiques au tore de mesure 34. Il est ainsi possible de mesurer le gain G et la phase P à la première fréquence $f_1$ (de pulsation $\omega_1$) pour les chaînes de mesure 32, 38 :

$$(G + j \cdot P) \cdot (Ir + j \cdot Ii) = (1/R_{et} + j \cdot \omega_1 \cdot C_{et}) \cdot (Ur + j \cdot Ui),$$

avec $j^2$ = -1, Ii et Ir (respectivement Ui et Ur) parties réelle et imaginaire de I (respectivement U). Une fois l'étalonnage terminé, c'est-à-dire que G et P sont quasi-constants et égaux, le déphasage $P_m$ et le gain $G_m$ ainsi déterminés des chaînes de mesure 32, 38 sont utilisés comme paramètres dans les déterminations de $Z_d$ avec $U_d$ et $I_d$ (ou de $Z_f$ avec

$U_0$ et $I_f$), grâce à deux mesures simultanées de la tension et du courant de défaut au niveau de la dérivation :

$$1/R_d + j \cdot \omega_1 \cdot C_d = (G_m + j \cdot P_m) \cdot (I_dr + j \cdot I_di) / (U_dr + j \cdot U_di) \qquad (1)$$

Grâce à cet étalonnage, une précision de $\pm$ 20 % sur les chaînes de mesure 32, 38 est suffisante. Il est à noter que le bon fonctionnement du produit peut en outre être vérifié par ce contrôle du gain et de la phase. Il peut être prévu de réaliser des étalonnages automatisés de façon cyclique pour prendre en compte les modifications des chaînes de mesure en fonction de la température.

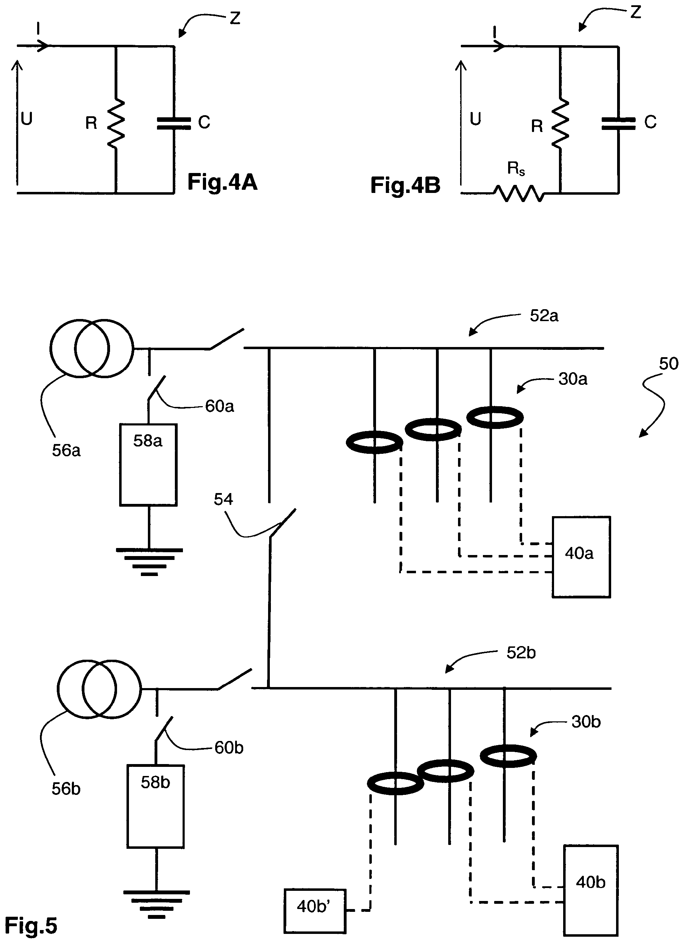

Tel que présenté dans l'équation (1), la détermination de l'impédance $Z_d$ de fuite locale est réalisée par l'intermédiaire des deux mesures, respectivement de $I_d$ et $U_d$, communiquées au système de traitement 40. Le système de traitement 40b' peut être local et associé à chaque dérivation ; selon une autre option 40a, le système de détermination 40 peut être centralisé de sorte que les moyens de détermination reçoivent les mesures de plusieurs dérivations en parallèle (voir schématisations en figure 5).

Si une simple indication quant à la valeur (présence) de l'impédance $Z_d$ est souhaitée, il est possible de déterminer son module par le rapport entre les amplitudes de $U_d$ et $I_d$ à la première fréquence $f_1$. Cependant, pour ne pas détecter de faux défaut, notamment par exemple dans le cas d'un départ de ligne avec une forte capacité, il est préférable de connaître au moins le caractère, capacitif ou résistif, de l'impédance de défaut $Z_d$. En effet, le réglage du seuil d'alarme d'un CPI 22 dépend de la capacité du réseau 20. Pour cette détermination de l'impédance de défaut locale $Z_d$ quant à sa nature résistive ou capacitive, une option selon l'invention consiste à procéder à deux mesures locales de $U_d$ et $I_d$ à deux fréquences distinctes $f_1$, $f_2$ : en effet, la résistance ne dépend pas de la fréquence contrairement à la capacité, qui lui est directement corrélée.

Selon un mode de réalisation, les moyens d'injection 24 du CPI 22 selon l'invention sont de fait capables d'injecter des signaux de courant à une première fréquence $f_1$ et à une deuxième fréquence $f_2$, avantageusement simultanément ; de préférence, la deuxième fréquence $f_2$ est un multiple de la première fréquence $f_1$, et notamment un multiple entier afin de pouvoir utiliser la période la plus longue comme base des mesures (si le multiple entre les fréquences d'injection est non entier, la période d'acquisition sera allongée pour avoir un nombre entier de périodes à $f_1$ et $f_2$). Les moyens de mesure locaux 32, 38 du dispositif 30 selon l'invention sont eux aussi capables de mesurer l'intensité $I_d$ et la tension $U_d$ de défaut à chacune des deux fréquences $f_1$, $f_2$. Suivant l'évolution du rapport entre les amplitudes de $U_d$ et $I_d$ mesurées à chacune des fréquences $f_1$ et $f_2$, une indication quant à la nature résistive ou capacitive du défaut $Z_d$ peut être obtenue. Notamment, si le rapport double pour $f_2$ = 5 Hz par rapport à $f_1$ = 2,5 Hz, alors le défaut $Z_d$ est purement capacitif (c'est-à-dire qu'il n'y a pas de fuite) ; par contre, si le rapport reste identique quelle que soit la fréquence, le défaut est purement résistif.

Pour simplifier le traitement au niveau du localisateur 40, il est préférable que le générateur 24 du CPI s'adapte à la capacité du réseau en fonction de la fréquence injectée. De fait, les composantes de fréquence élevée sont plus atténuées que les composantes de plus basse fréquence : pour conserver une même valeur efficace $\|U_d\|$ à chaque composante de fréquence $f_1$, $f_2$, il est avantageux d'asservir les tensions d'injection $U_0$ sur chaque fréquence $f_1$, $f_2$ du signal d'injection pour avoir une amplitude d'injection $\|U_0\|$ constante pour chaque harmonique indépendamment de la capacité du réseau 20. La détermination de la nature de l'impédance en est ainsi encore facilitée : sans même mesurer la tension $U_d$ locale, simplement par l'analyse du courant $I_d$ circulant dans la dérivation, la comparaison entre le rapport de deux fréquences $f_1/f_2$ d'injection et le rapport entre les intensités de $I_d$ en résultant, permet de vérifier la nature résistive (si le rapport des intensités est égal au rapport des fréquences) ou capacitive (si le rapport des intensités est égal à 1). Le dispositif de mesure 30 est alors très bon marché.

Il est possible d'affiner ce résultat par l'intermédiaire d'une troisième fréquence $f_3$, en particulier pour des défauts comprenant les deux composantes résistive et capacitive. Plus généralement, le CPI 22 génère un signal de tension homopolaire composite formé de la somme de n signaux sinusoïdaux (de préférence n = 3). Avantageusement, les injections simultanées sont réalisées avec une différence de phases sélectionnée pour maximiser les signaux.

Dans la majorité des cas, il est préféré de connaître les caractéristiques de l'impédance $Z_d$, et notamment la valeur de la résistance $R_d$ et de la capacité $C_d$ en parallèle. A cette fin, pour résoudre l'équation (1), le système de traitement 40 du dispositif 30 selon l'invention comprend avantageusement des moyens 42 pour déterminer la partie réelle et la partie imaginaire du rapport entre tension $U_d$ et intensité $I_d$; de préférence, ces moyens 42 sont adaptés pour faire une démodulation synchrone : à la fin d'une acquisition de mesures, c'est-à-dire après au moins une période $1/f_1$ du signal d'injection, chaque échantillon est multiplié par les fonctions sinus et cosinus pour avoir les parties réelle et imaginaire du signal. Comme les deux mesures de tension et d'intensité concernent la même dérivation D, le référentiel de démodulation synchrone entre $U_d$ et $I_d$ est local, et il n'est pas nécessaire de se rapporter au référentiel utilisé pour le CPI 22 ; pour cette raison également, il est préféré d'opérer par deux mesures simultanées. La mesure locale conjointe selon l'invention permet ainsi de déterminer l'impédance d'isolement $Z_d$ d'un départ D sans aucune connexion filaire avec le CPI 22, uniquement par le système de traitement 40 et l'équation (1) : en particulier dans le cas d'un réseau 20 étendu, cette absence de bus de communication est intéressante.

Les résultats obtenus par le système 40 quant à la nature de l'impédance $Z_d$ et/ou ses caractéristiques $C_d$, $R_d$ peuvent être mis à disposition de l'utilisateur localement, par exemple par un écran 44, au niveau de chaque dispositif 30. En particulier dans le cas où plusieurs dérivations sont contrôlées en même temps, il est possible également de centraliser les informations au niveau d'un dispositif 30 de localisation particulier, et/ou d'un système central de type écran d'ordinateur 46 et/ou au niveau approprié 28 du CPI injecteur 22. Il est possible également, tel que schématisé en figure 5, de réaliser le traitement par un système de détermination 40a, 40b pour plusieurs dérivations. Les éléments concernés 22, 40 sont reliés par des moyens de communication adaptés 48, 48', qui servent alors uniquement à la remontée des informations et ne sont pas nécessaires à la mesure : leur réalisation est plus simple que dans l'art antérieur et toutes les options connues sont possibles (bus, réseau filaire, voire communication sans fil).

Grâce au dispositif 30 selon l'invention, l'impédance de défaut $Z_d$ peut donc être déterminée localement et de façon précise en allégeant l'architecture et la mise en place des composants de surveillance d'un réseau 20. Par ailleurs, grâce au choix selon l'invention, les résultats sur $Z_d$ sont fiables même quand la mise à la terre de la dérivation D n'est pas uniforme avec la terre principale du CPI 22. En effet, tel que schématisé en figure 2, il est fréquent que les différents points de prises de terre soient séparés par une résistance $R_t$. Selon l'invention, comme les mesures de $I_d$ et de $U_d$ sont locales et comme le calcul de l'impédance $Z_d$ est effectué sans référence aux caractéristiques du circuit principal, le résultat obtenu est conforme à l'impédance locale, et insensible à une éventuelle résistance en série.

Cet avantage concernant l'insensibilité à une résistance de terre $R_t$ peut être transposé à la présence d'une résistance en série quelconque par rapport au défaut mesuré. En effet, le modèle classique d'une impédance Z à mesurer est une mise en série d'une résistance R et d'une capacité C tel qu'illustré en figure 4A ; cependant, dans certains cas, le modèle est incomplet et un circuit avec une résistance série $R_s$ est plus représentatif : voir figure 4B (en particulier, dans le schéma illustré en figure 2, l'impédance de fuite $Z_f$ globale consisterait en un circuit parallèle de $R_f$ et $C_f$ mis en série avec la résistance $R_t$).

Dans le modèle de la figure 4B, pour mesurer correctement R, C et $R_s$, tant au niveau local que global, il faut un paramètre de plus. Avec les deux fréquences d'injection, ce nouveau paramètre peut ainsi être une nouvelle fréquence d'injection par le CPI 22; par contre, comme des valeurs de la résistance R et de la capacité C sont souhaitées, une démodulation synchrone sur chaque fréquence $f_1$, $f_2$ sera réalisée afin de déterminer la partie réelle et la partie imaginaire du rapport entre la tension et l'intensité du courant circulant dans l'impédance de fuite. La démodulation synchrone éliminant toutes les hamoniques d'un signal et ne prenant en compte que le fondamental, il est préconisé que les deux fréquences d'injection $f_1$ et $f_2$ soient multiples l'une de l'autre. Ici encore, pour diminuer la durée d'acquisition des signaux, il est préféré que le rapport entre les deux fréquences soit entier.

Dans cette alternative de mesure et calcul, I et U sont mesurés à chacune des fréquences $f_1$, $f_2$, au niveau global par les moyens de mesure 26 ou sur une dérivation par les moyens de mesure 32, 38 du dispositif 30 selon l'invention. Selon l'équation (1), et en prenant le modèle usuel de la figure 4A, on obtient deux valeurs C et R à $f_1$ et $f_2$. Par ailleurs, il est possible d'obtenir une troisième valeur de R et C, ainsi qu'une valeur de $R_s$, grâce à la valeur de l'impédance de fuite Z à chacune des fréquences $f_1$, $f_2$ et au rapport $f_1/f_2$ entre les deux fréquences en prenant le schéma de la figure 4B. Les trois résultats peuvent alors être comparés pour éliminer les valeurs aberrantes et vérifier la validité du modèle de la figure 4A ou de la figure 4B.

Il peut être souhaitable de procéder à une troisième mesure avec une troisième fréquence $f_3$, permettant ainsi d'obtenir trois valeurs de R et C avec le premier modèle de la figure 4A, et une quatrième de R et C avec le deuxième modèle de la figure 4B et les deux fréquences extrêmes. Cette option permet en particulier de vérifier l'absence de perturbations notables et d'éliminer les valeurs obtenues avec une éventuelle fréquence proche de la perturbation.

Un autre avantage du principe de mesures indépendantes de la tension injectée $U_0$ par le dispositif 30 selon l'invention réside dans le fait que la nature du CPI injecteur 22 est indifférente au résultat obtenu. En particulier, certaines installations d'alimentation électrique 50 schématisées en figure 5 sont réalisées en plusieurs parties 52a, 52b reliées entre elles par des dispositifs de coupure 54 et que l'on peut isoler ou coupler. On peut ainsi considérer chacune des parties 52 comme un réseau indépendant, dont les transformateurs 56 sont munis d'un CPI 58. Chaque CPI 58a, 58b est alors associé à des moyens d'exclusion 60a, 60b : en effet, afin d'obtenir des résultats corrects, aucune injection d'un CPI 58a dans un autre CPI 58b n'a lieu et les moyens d'exclusion 60 gèrent la configuration (voir aussi document FR 2 679 039). Ainsi, dans le cas où le couplage 54 est ouvert, les deux CPI 58 injectent et les deux « interrupteurs » 60 sont fermés ; si le couplage 54 est fermé, seul un CPI 58a est actif et l'autre moyen d'exclusion 60b est ouvert.

Chacun des réseaux 52 peut comprendre des dérivations sur lesquelles sont placés des dispositifs 30a, 30b selon l'invention associés aux CPI 58a, 58b ; en fonction des coupures 54, 60 entre CPI 58, les dérivations reçoivent donc le courant injecté par l'un ou l'autre. Dans les procédés et dispositifs de mesure classiques, il était indispensable de connaître le CPI injecteur 58a, 58b pour donner une valeur de l'impédance de défaut locale, en raison du rapport de démodulation. Grâce au dispositif 30 selon l'invention, un affranchissement total des CPI 58 (hormis la connaissance de la fréquence injectée $f_1$) est obtenu.

En particulier, le dispositif selon l'invention peut être utilisé conjointement avec la gestion des exclusions de contrôleurs d'isolement d'une installation multi-réseaux décrite dans la demande de brevet français FR 07 04427 (publiée sous le numéro FR 2 917 839 A1) intitulée « *Contrôle d'isolement d'un ensemble de réseaux électriques interconnectables à neutre isolé* ».

Grâce à la solution selon l'invention sont, entre autres, obtenus les avantages suivants :

- les dispositifs 30 selon l'invention et les CPI injecteurs 22 peuvent être indépendants ; ils sont éventuellement reliés par des moyens de communication 48, qui cependant n'ont aucun besoin de comprendre un bus de communication synchrone ;
- la présence de la résistance terre en série $R_t$ entre injection et dérivation n'est plus source d'erreurs de mesure ;
- le dispositif de localisation 30 est indépendant de la tension injectée $U_0$, qu'il peut ignorer ;
- dans les cas d'installations multi-réseaux d'alimentation 50 avec couplage 54 (par exemple normal/secours, sources en parallèle, etc.), le dispositif de localisation 30 est indépendant du CPI injecteur 58, et il n'est donc plus nécessaire de signaler tout changement à chaque reconfiguration de réseau électrique 50.

Bien que l'invention ait été décrite en référence à un réseau triphasé 20 sur le neutre duquel est branché le contrôleur permanent d'isolement 22, elle ne s'y limite pas : la solution proposée peut être appliquée à des alimentations différentes, par exemple de fréquence autre que 50 Hz ou monophasée, ou des groupes de secours de type groupe électrogène ou onduleur ou des sources de tension continue, et/ou le contrôleur d'isolement peut injecter son signal sur une phase du réseau (figure 5) et/ou l'injection peut être continue pour des réseaux purement alternatifs. Dans tous les cas, la mesure de l'intensité $I_d$ et de la tension $U_d$ concerne le courant de défaut et s'applique à l'ensemble de la ligne concernée ; notamment, le tore de détection entoure tous les conducteurs d'alimentation. De la même façon, le CPI peut fonctionner sur un autre principe que la démodulation synchrone.

## Revendications

1. Dispositif de mesure (30) de l'isolement d'une dérivation (D) d'un réseau électrique (20) à neutre isolé dans lequel des moyens (24) sont configurés pour injecter dans le réseau électrique un signal de courant alterné d'une première fréquence ($f_1$) et d'une deuxième fréquence ($f_2$), ledit dispositif (30) comprenant :

   - des moyens (32) de mesure du courant de défaut ($I_d$) à la première fréquence ($f_1$) et à la deuxième fréquence ($f_2$) pour être placés sur la dérivation (D) comprenant un tore de détection (34) adapté pour entourer la ligne d'alimentation de ladite dérivation (D) ;
   - des moyens (38) de mesure de la tension de défaut ($U_d$) à la première fréquence ($f_1$) et à la deuxième fréquence ($f_2$) placés sur la dérivation (D) ;
   - un système (40) de détermination de l'impédance de défaut ($Z_d$) de la dérivation (D)

   **caractérisé en ce que** :

   - les moyens (24) comportent des moyens d'asservissement de la tension injectée (U0) de façon à avoir une amplitude d'injection constante à la première et à la deuxième fréquence (f1, f2) indépendamment de la capacité du réseau électrique (20), et
   - le système (40) de détermination de l'impédance de défaut comporte des moyens d'évaluation de la nature résistive ou capacitive de l'impédance de défaut ($Z_d$) de la dérivation (D), par comparaison du rapport des première et deuxième fréquences d'injection (f1/f2) et du rapport entre les amplitudes du courant de défaut $I_d$ à la première et à la deuxième fréquence ($f_1$, $f_2$) mesurés sur ladite dérivation.

2. Dispositif selon la revendication 1 dans lequel les moyens de mesure (32, 38) placés sur la dérivation (D) sont adaptés pour mesurer simultanément le courant et la tension de défaut ($I_d$, $U_d$) à la première fréquence ($f_1$).

3. Dispositif selon la revendication 2 pour un réseau (20) dans lequel les signaux de courant de première fréquence ($f_1$) et de deuxième fréquence ($f_2$) injectés sont simultanés, dans lequel les moyens (32, 38) de mesure du courant et de la tension de défaut ($I_d$, $U_d$) sont adaptés pour mesurer simultanément le courant et la tension à la première et à la deuxième fréquence ($f_1$, $f_2$).

4. Dispositif selon l'une des revendications 2 ou 3 comprenant en outre des moyens d'étalonnage pour mesurer le gain et la phase des moyens de mesure (32, 38).

5. Dispositif selon l'une des revendications 1 à 4 dans lequel le système de détermination (40) comprend des moyens (42) pour déterminer la partie réelle et la partie imaginaire du rapport entre le courant et la tension de défaut ($I_d$, $U_d$) mesurés pour la dérivation (D).

6. Dispositif selon l'une des revendications 1 à 5 dans lequel les moyens (24) injectent simultanément un signal de courant alterné d'une première fréquence ($f_1$), d'une deuxième fréquence ($f_2$) et d'une troisième fréquence ($f_3$), dans lequel les moyens (32) de mesure du courant de défaut ($I_d$) et les moyens (38) de mesure de la tension de défaut ($U_d$) sont en outre adaptés pour mesurer simultanément le courant et la tension aux première, deuxième et troisième fréquences ($f_1$, $f_2$, $f_3$).

7. Dispositif selon la revendication 6 dans lequel les moyens d'asservissement de la tension injectée ($U_0$) sont adaptés pour avoir une amplitude constante à chaque fréquence ($f_1$, $f_2$, $f_3$).

8. Dispositif selon la revendication 7 dans lequel les fréquences ($f_1$, $f_2$, $f_3$) sont des multiples l'une de l'autre.

9. Dispositif selon l'une des revendications 1 à 8 dans lequel le système de détermination (40) comprend des moyens (42) pour déterminer la partie réelle et la partie imaginaire du rapport entre la tension et le courant de défaut ($U_d$, $I_d$) mesurés à chaque fréquence ($f_1$, $f_2$, $f_3$) pour chaque dérivation (D) à contrôler.

10. Dispositif électrotechnique de contrôle de l'isolement d'au moins une dérivation (D) d'un réseau électrique (20) à neutre isolé comprenant des moyens (24) pour injecter un signal de courant alterné d'une première fréquence ($f_1$) et d'une deuxième fréquence ($f_2$) dans le réseau (20) et un dispositif selon l'une des revendications 1 à 9 pour chaque dérivation (D) à contrôler.

11. Dispositif électrotechnique selon la revendication 10 comprenant en outre des moyens de liaison (48) entre les moyens pour injecter un signal de courant alterné (24) et le système de détermination (40) pour centraliser les résultats.

12. Réseau de distribution électrique (20) muni d'au moins une dérivation (D), comprenant des moyens pour générer et injecter un signal alternatif de fréquence propre ($F_0$) et dont le neutre est isolé, comprenant un dispositif électrotechnique selon l'une des revendications 10 ou 11 pour contrôler l'isolement du réseau et d'au moins une dérivation.

**Patentansprüche**

1. Vorrichtung zum Messen (30) einer Abzweigung (D) eines Stromnetzes (20) mit isoliertem Neutralleiter, wobei Mittel (24) konfiguriert sind, um ein Wechselstromsignal von einer ersten Frequenz ($f_1$) und einer zweiten Frequenz ($f_2$) in das Stromnetz zu injizieren, wobei die Vorrichtung (30) Folgendes aufweist:

  - Mittel (32) zum Messen des Fehlerstroms ($I_d$) an der ersten Frequenz ($f_1$) und an der zweiten Frequenz ($f_2$), um auf der Abzweigung (D) angeordnet zu werden, umfassend einen Erfassungstorus (34), der geeignet ist, die Versorgungsleitung der Abzweigung (D) zu umgeben;
  - Mittel (38) zum Messen der Fehlerspannung ($U_d$) an der ersten Frequenz ($f_1$) und an der zweiten Frequenz ($f_2$), die auf der Abzweigung (D) angeordnet sind;
  - ein System (40) zum Bestimmen der Fehlerimpedanz ($Z_d$) der Abzweigung (D),

  **dadurch gekennzeichnet, dass**:

  - die Mittel (24) Mittel zum Regeln der injizierten Spannung (U0) derart aufweisen, um an der ersten und an der zweiten Frequenz ($f_1$, $f_2$) unabhängig von der Kapazität des Stromnetzes (20) eine konstante Injektionsamplitude aufzuweisen und
  - das System (40) zum Bestimmen der Fehlerimpedanz Mittel zum Beurteilen des resistiven oder kapazitiven Charakters der Fehlerimpedanz ($Z_d$) der Abzweigung (D) durch Vergleichen des Verhältnisses zwischen der ersten und zweiten Injektionsfrequenz ($f_1$, $f_2$) und des Verhältnisses zwischen den Amplituden des Fehlerstroms $I_d$ an der ersten und an der zweiten Frequenz ($f_1$, $f_2$), die an der Abzweigung gemessen werden, aufweist.

2. Vorrichtung nach Anspruch 1, wobei die Mittel zum Messen (32, 38), die auf der Abzweigung (D) angeordnet sind, geeignet sind, gleichzeitig den Fehlerstrom und die Fehlerspannung ($I_d$, $U_d$) an der ersten Frequenz ($f_1$) zu messen.

**3.** Vorrichtung nach Anspruch 2 für ein Netz (20), wobei die injizierten Stromsignale der ersten Frequenz ($f_1$) und der zweiten Frequenz ($f_2$) gleichzeitig sind, wobei die Mittel (32, 38) zum Messen des Fehlerstroms und der Fehlerspannung ($I_d$, $U_d$) geeignet sind, um gleichzeitig den Strom und die Spannung an der ersten Frequenz und an der zweiten Frequenz ($f_1$, $f_2$) zu messen.

**4.** Vorrichtung nach einem der Ansprüche 2 oder 3, ferner umfassend Kalibriermittel, um die Verstärkung und die Phase der Mittel zum Messen (32, 38) zu messen.

**5.** Vorrichtung nach einem der Ansprüche 1 bis 4, wobei das System zum Bestimmen (40) Mittel (42) aufweist, um den Realteil und den Imaginärteil des Verhältnisses zwischen dem Fehlerstrom und der Fehlerspannung ($I_d$, $U_d$), die für die Abzweigung (D) gemessen werden, zu bestimmen.

**6.** Vorrichtung nach einem der Ansprüche 1 bis 5, wobei die Mittel (24) gleichzeitig ein Wechselstromsignal einer ersten Frequenz ($f_1$), einer zweiten Frequenz ($f_2$) und einer dritten Frequenz ($f_3$) injizieren, wobei die Mittel (32) zum Messen des Fehlerstroms ($I_d$) und die Mittel (38) zum Messen der Fehlerspannung ($U_d$) ferner geeignet sind, um gleichzeitig den Strom und die Spannung an der ersten, zweiten und dritten Frequenz ($f_1$, $f_2$, $f_3$) zu messen.

**7.** Vorrichtung nach Anspruch 6, wobei die Mittel zum Regeln der injizierten Spannung ($U_0$) geeignet sind, um bei jeder Frequenz ($f_1$, $f_2$, $f_3$) eine konstante Amplitude aufzuweisen.

**8.** Vorrichtung nach Anspruch 7, wobei die Frequenzen ($f_1$, $f_2$, $f_3$) Vielfache voneinander sind.

**9.** Vorrichtung nach einem der Ansprüche 1 bis 8, wobei das System zum Bestimmen (40) Mittel (42) aufweist, um den Realteil und den Imaginärteil des Verhältnisses zwischen der Fehlerspannung und dem Fehlerstrom ($U_d$, $I_d$), die bei jeder Frequenz ($f_1$, $f_2$, $f_3$) für jede zu kontrollierende Abzweigung (D) gemessen werden, zu bestimmen.

**10.** Elektronische Vorrichtung zum Kontrollieren der Isolierung von mindestens einer Abzweigung (D) eines Stromnetzes (20) mit isoliertem Neutralleiter, umfassend Mittel (24), um ein Wechselstromsignal von einer ersten Frequenz ($f_1$) und einer zweiten Frequenz ($f_2$) in das Netz (20) zu injizieren, und eine Vorrichtung nach einem der Ansprüche 1 bis 9 für jede zu kontrollierende Abzweigung (D).

**11.** Elektronische Vorrichtung nach Anspruch 10, ferner umfassend Verbindungsmittel (48) zwischen den Mitteln, um ein Wechselstromsignal (24) zu injizieren, und dem System zum Bestimmen (40), um die Ergebnisse zentral zu sammeln.

**12.** Stromnetz (20), das mit mindestens einer Abzweigung (D) versehen ist, umfassend Mittel zum Erzeugen und Injizieren eines eigenen Wechselstromsignals (Fo) und dessen Neutralleiter isoliert ist, umfassend eine elektronische Vorrichtung nach einem der Ansprüche 10 oder 11, um die Isolierung des Netzes und von mindestens einer Abzweigung zu kontrollieren.

**Claims**

**1.** Device (30) for measuring the isolation of a tap-off (D) of an electrical network (20) with isolated neutral, wherein means (24) are configured to inject an AC signal of a first frequency ($f_1$) and of a second frequency ($f_2$) into the electrical network, said device (30) comprising:

- means (32) for measuring the fault current ($I_d$) at the first frequency ($f_1$) and at the second frequency ($f_2$), to be positioned across the tap-off (D), comprising a detection torus (34) designed to surround the power supply line of said tap-off (D);
- means (38) for measuring the fault voltage ($U_d$) at the first frequency ($f_1$) and at the second frequency ($f_2$), positioned across the tap-off (D);
- a system (40) for determining the fault impedance ($Z_d$) of the tap-off (D)

**characterized in that**:

- the means (24) include means for servo-controlling the injected voltage (U0) in such a way as to have a constant injection amplitude at the first and at the second frequency (f1, f2), independently of the capacity of the electrical network, and

- the system (40) for determining the fault impedance includes means for evaluating the resistive or capacitive nature of the fault impedance ($Z_d$) of the tap-off (D), by comparing the ratio of the first and second injection frequencies (f1/f2) and the ratio between the amplitudes of the fault current $I_d$ at the first and at the second frequency ($f_1$, $f_2$) measured across said tap-off.

2. Device according to Claim 1, wherein the measuring means (32, 38) positioned across the tap-off (D) are designed to simultaneously measure the fault current and the fault voltage ($I_d$, $U_d$) at the first frequency $f_1$).

3. Device according to Claim 2 for a network (20) in which the injected current signals of a first frequency ($f_1$) and of a second frequency ($f_2$) are simultaneous, wherein the means (32, 38) for measuring the fault current and the fault voltage ($I_d$, $U_d$) are designed to simultaneously measure the current and the voltage at the first and at the second frequency ($f_1$, $f_2$).

4. Device according to either of Claims 2 and 3, furthermore comprising calibrating means for measuring the gain and the phase of the measuring means (32, 38).

5. Device according to one of Claims 1 to 4, wherein the determination system (40) comprises means (42) for determining the real part and the imaginary part of the ratio between the fault current and the fault voltage ($I_d$, $U_d$) that are measured for the tap-off (D).

6. Device according to one of Claims 1 to 5, wherein the means (24) simultaneously inject an AC signal of a first frequency ($f_1$), of a second frequency ($f_2$) and of a third frequency ($f_3$), wherein the means (32) for measuring the fault current ($I_d$) and the means (38) for measuring the fault voltage ($U_d$) are furthermore designed to simultaneously measure the current and the voltage at the first, second and third frequencies ($f_1$, $f_2$, $f_3$).

7. Device according to Claim 6, wherein the means for servo-controlling the injected voltage ($U_0$) are designed to have a constant amplitude at each frequency ($f_1$, $f_2$, $f_3$).

8. Device according to Claim 7, wherein the frequencies ($f_1$, $f_2$, $f_3$) are multiples of one another.

9. Device according to one of Claims 1 to 8, wherein the determination system (40) comprises means (42) for determining the real part and the imaginary part of the ratio between the fault voltage and the fault current ($U_d$, $I_d$) that are measured at each frequency ($f_1$, $f_2$, $f_3$) for each tap-off (D) to be monitored.

10. Electrotechnical device for monitoring the isolation of at least one tap-off (D) of an electrical network (20) with isolated neutral, comprising means (24) for injecting an AC signal of a first frequency ($f_1$) and of a second frequency ($f_2$) into the network (20) and a device according to one of Claims 1 to 9 for each tap-off (D) to be monitored.

11. Electrotechnical device according to Claim 10, furthermore comprising means (48) for linking between the means (24) for injecting an AC signal and the determination system (40) in order to centralize the results.

12. Electrical distribution network (20) equipped with at least one tap-off (D), comprising means for generating and injecting an alternating signal of natural frequency ($F_0$) and in which the neutral is isolated, comprising an electrotechnical device according to either of Claims 10 and 11 for monitoring the isolation of the network and of at least one tap-off.

**Fig.1**

**Fig.2**

EP 2 006 694 B1

Fig.3

EP 2 006 694 B1

13

**Fig.4A**

**Fig.4B**

**Fig.5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2647220
- DE 10143595
- FR 2676821
- DE 10307972 A1
- JP 2007071774 A
- EP 0593007 A2
- US 5495384 A
- FR 2679039
- FR 0704427
- FR 2917839 A1